# EUROPÄISCHE PATENTANMELDUNG

(11) **EP 1 951 008 A1**
(43) Veröffentlichungstag der Anmeldung: **30.07.2008**
(21) Anmeldenummer: 07101119.1
(22) Anmeldetag: 24.01.2007
(51) Int. Cl.: H05K 1/00, H01L 33/00, H05K 3/00

(54) **Verfahren zur Herstellung flexibler elektrischer Vorrichtungen und flexible elektrische Vorrichtung**

(71) Anmelder: Asetronics AG, 3018 Bern 18 (CH)
(72) Erfinder: Piller, Hugo, CH-3127, Mühlethurnen (CH)
(74) Vertreter: Rutz & Partner

(57) **Zusammenfassung**

Das Verfahren dient der Herstellung flexibler elektrischer Vorrichtungen (100), wie flexibler Flachkabel und flexibler Leiterplatten, die mit wenigstens zwei vollständig voneinander getrennten Kühlkörpern (120) versehen sind, welche der Aufnahme der Verlustwärme von elektrischen Bauteilen (2,200), wie Halbleiter, Leuchtdioden, Halbleiterschaltmittel, etc. dienen. Erfindungsgemäss wird das einseitig mit einer Isolationsschicht (11) und mit einer aussen liegenden Metallschicht (10) versehene Metallsubstrat (12) eines gegebenenfalls in vorhergehenden Schritten vorbearbeiteten Isolierten Metallsubstrats bzw. IMS (1) mittels eines Werkzeugs (92) derart bearbeitet, dass wenigstens ein Segment (12') des Metallsubstrats (12) vollständig von der Isolationsschicht (11) abgetrennt wird, so dass das Metallsubstrat (12) in zwei oder mehrere Kühlkörper (120) aufgeteilt wird, die durch die freigelegte Isolationsschicht (11) miteinander verbunden sind. Flexibler elektrischer Vorrichtungen (100), können daher kostengünstig, in beliebiger Individualität und hohen Produktdichten gefertigt werden, was insbesondere für die Verwendung im Automobilbau von Vorteil ist.

## Beschreibung

Die Erfindung betrifft ein Verfahren zur Herstellung flexibler elektrischer Vorrichtungen, wie flexible Flachkabel und flexible Leiterplatten, die mit wenigstens zwei vollständig voneinander getrennten Kühlkörpern versehen sind, die der Aufnahme der Verlustwärme elektrischer Bauteile dienen.

Die Erfindung betrifft insbesondere ein Verfahren zur Fertigung von flexiblen Flachkabeln und flexiblen Leiterplatten, die mit Leuchtdioden (LED) bestückt sind, deren Verlustwärme von den zugeordneten Kühlkörpern aufgenommen wird.

Ferner betrifft die Erfindung nach dem erfindungsgemässen Verfahren hergestellte flexible Flachkabel und flexible Leiterplatten.

Flexible Flachkabel (FFC (Flexible Flat Cable), FLC (Flat Laminated Cable), ExFC (Extruded Flat Cable)) oder flexible Leiterplatten (FPC bzw. FPCB (Flat Printed Circuit Boards)), deren Herstellungsprozesse sowie deren Verwendung insbesondere im Automobilbau sind beispielsweise in [1], US2006169481A1, [2], DE102004061425A1 und [3], DE10051269A1 beschrieben.

Gemäss [1] umfassen konventionelle Flachkabel eine Anordnung von metallischen Leiterbahnen, die in dielektrischen Filmen einlaminiert sind. Derartige Flachkabel bestehen üblicherweise aus flexiblen, isolierenden Filmen beispielsweise aus Polyester, Polyvinyl, Polyethylen, Polyimid oder Polycarbonat. Flexible Flachkabel werden typischerweise gefertigt, indem elektrische Leiter zwischen zwei isolierenden Schichten angeordnet werden, die anschliessend mittels eines vorzugsweise thermisch aktiven Klebers miteinander sowie mit den elektrischen Leitern verbunden werden.

Ferner kann das flexible Flachkabel oder die flexible Leiterplatte vorzugsweise mittels eines Klebers mit wenigstens einem Kühlkörper verbunden werden. Die Bestückung des flexiblen Flachkabels oder der flexiblen Leiterplatte mit Bauteilen, insbesondere Halbleitern, wie Schalteinheiten oder Energiewandlern, kann vollzogen werden bevor oder nachdem das flexible Flachkabel oder die flexible Leiterplatte mit dem Kühlkörper verbunden wird.

Beispielsweise kann ein flexibles Flachkabel mit mehreren Kühlkörpern, beispielsweise Segmenten einer Aluminiumplatte verbunden und anschliessend mit Leuchtdioden (LED) bestückt werden. Das resultierende Band kann anschliessend in einem Automobil montiert werden, indem die als Kühlkörper dienenden Aluminiumplatten mit Strukturteilen eines Fahrzeugs verbunden, beispielsweise verklebt werden.

Diese an sich vorteilhafte Technologie weist auch Nachteile auf. Insbesondere verlaufen verschiedene Fertigungsprozesse getrennt voneinander ab und werden erst abschliessend zusammengeführt, wodurch hinsichtlich des Materials und der Arbeitsprozesse höhere Aufwendungen resultieren. Einerseits wird das flexible Flachkabel oder die flexible Leiterplatte gefertigt. Andererseits werden die Kühlkörper gefertigt und positioniert. Anschliessend erfolgen gegebenenfalls die Bestückungsprozesse, die jedoch nur erfolgreich vollzogen werden können, wenn die vorangehenden Prozesse einwandfrei durchgeführt wurden. Zu beachten ist ferner, dass die zu Beginn parallel verlaufenden Prozesse zumindest teilweise aufeinander abgestimmt werden müssen, wodurch Restriktionen resultieren, welche eine Produktoptimierung, insbesondere die Realisierung höherer Packungsdichten behindern.

Der vorliegenden Erfindung liegt daher die Aufgabe zugrunde, ein verbessertes Verfahren zur Herstellung flexibler elektrischer Vorrichtungen, insbesondere flexibler Flachkabel oder flexibler Leiterplatten anzugeben, die mit wenigstens zwei voneinander getrennten Kühlkörpern versehen sind.

Insbesondere ist ein Verfahren anzugeben, welches erlaubt, mit wenigstens zwei Metallkörpern versehene flexible Flachkabel oder flexible Leiterplatten den individuellen Anforderungen des Anwenders entsprechend mit hohen Packungsdichten kostengünstig herzustellen.

Ferner sind nach dem erfindungsgemässen Verfahren gefertigte, verbesserte flexible Flachkabel oder flexible Leiterplatten anzugeben.

Die Lösung dieser Aufgabe gelingt mit den in Patentanspruch 1 bzw. 8 angegebenen Massnahmen. Vorteilhafte Ausgestaltungen der Erfindung sind in weiteren Ansprüchen definiert.

Das Verfahren dient der Herstellung flexibler elektrischer Vorrichtungen, wie flexibler Flachkabel und flexibler Leiterplatten, die mit wenigstens zwei vollständig voneinander getrennten Kühlkörpern versehen sind, welche der Aufnahme der Verlustwärme von elektrischen Bauteilen, wie Halbleiter, Leuchtdioden, Halbleiterschaltmittel, etc. dienen. Erfindungsgemäss wird das einseitig mit einer Isolationsschicht und mit einer aussen liegenden Metallschicht versehene Metallsubstrat eines gegebenenfalls in vorhergehenden Schritten vorbearbeiteten Isolierten Metallsubstrats bzw. IMS mittels eines Werkzeugs derart bearbeitet, dass wenigstens ein Segment des Metallsubstrats vollständig von der Isolationsschicht abgetrennt wird, so dass das Metallsubstrat in zwei oder mehrere Kühlkörper aufgeteilt wird, die durch die freigelegte flexible Isolationsschicht miteinander verbunden sind.

Isolierte Metallsubstrate bzw. IMS sind beispielsweise aus [4], EP 1 635 403 A1 bekannt. In [4] sind Isolierte Metallsubstrate bzw. IMS derart bearbeitet, dass sie gebogen und in vorteilhafter Weise an einen Montagekörper angepasst werden können, so dass Wärmeenergie an diesen Montagekörper abgeleitet werden kann. Im Unterschied zu einem flexiblen Flachkabel bzw. zu einer flexiblen Leiterplatte bestehen jedoch erhebliche Beschränkungen.

Erfindungsgemässe flexible elektrische Vorrichtungen, wie flexible Flachkabel und flexible Leiterplatten, können daher kostengünstig, beispielsweise im Nutzen anhand von parallel laufenden Fertigungsprozessen, in beliebiger Individualität und hohen Produktdichten gefertigt werden, was insbesondere für die Verwendung im Automobilbau von Vorteil ist.

Das isolierte Metallsubstrat bzw. IMS kann in jedem Fertigungszustand erfindungsgemäss bearbeitet werden. In der der Freilegung der Isolationsschicht vor oder nachfolgenden Schritten, wird/werden
a) eine Lackmaske auf die aussen liegende Metallschicht aufgetragen; und/oder
b) die aussen liegende Metallschicht gegebenenfalls mittels Ätzmitteln bearbeitet, um Leiterbahnen oder Reflexionszonen zu bilden; und/oder
c) wenigstens eine Vertiefung durch die Isolationsschicht in das Metallsubstrat eingearbeitet; und/oder
d) elektrische Bauteile, wie Schaltmittel und Leuchtdioden, gegebenenfalls innerhalb der Vertiefung, mit den Leiterbahnen verbunden; und/oder
e) Schichten, gegebenenfalls Schutz- oder Veredelungsschichten aus Materialien wie Lack, Kunststoff, Metall, Edelmetall, etc. aufgetragen.

Zur Bearbeitung des Isolierten Metallsubstrats bzw. IMS wird dieses vorzugsweise mit der Isolationsschicht nach unten auf einen Werktisch gelegt und das von einer Steuereinheit gesteuerte Werkzeug soweit in das Metallsubstrat eingesenkt, bis der zwischen dem Werktisch und dem Werkzeug resultierende elektrische Widerstand, der von der Steuereinheit gemessen und überwacht wird, einen vorgesehenen Schwellwert unterschreitet. Auf diese Weise kann das Metallsubstrat mit einer Präzision im Bereich von 10⁻⁶ m bearbeitet werden, weshalb dieses in den gewählten Zonen vollständig von der Isolationsschicht abgetragen werden kann, ohne diese zu beschädigen. Die zu bearbeitenden Zonen können dabei frei gewählt werden, so dass Flachkabel und flexible Leiterplatten oder Kombinationen davon entsprechend den individuellen Wünschen des Anwenders realisierbar sind. Dazu werden eine oder mehrere flexible elektrische Vorrichtungen in einer für die Verwendung erforderlichen Form aus dem Isolierten Metallsubstrat bzw. IMS ausgeschnitten. Die Form der Kühlkörper kann individuell an die Form des Montagekörpers angepasst werden, so dass diese vorteilhaft montierbar sind.

Die Dicke und Beschaffenheit der Isolationsschicht und/oder der elektrischen Leiterbahnen wird entsprechend der erforderlichen Festigkeit der Verbindung zwischen den Kühlkörpern gewählt. Möglich ist ein mehrlagiger Aufbau mit Schichten, die entsprechend der vorliegenden Anwendung gewählt werden. Die Isolationsschicht besteht vorzugsweise aus Polyester, Polyvinyl, Polyethylen, Polyimid oder Polycarbonat. Das Metallsubstrat besteht vorzugsweise aus Aluminium oder Kupfer.

Die Klebeverbindung und der Kleber zwischen der Isolationsschicht und dem Metallsubstrat wird in einer vorzugsweisen Ausgestaltung der Erfindung derart gewählt, dass Metallsegmente peripher freigelegt und abgelöst werden können. Dadurch kann das abzulösende Segment des Metallsubstrats mit geringem Aufwand peripher von benachbarten Segmenten des Metallsubstrats getrennt und anschliessend von der Isolationsschicht abgelöst werden. Sofern der Kleber noch nicht vollständig ausgehärtet ist, ist dies besonders einfach möglich. In einer weiteren vorzugsweisen Ausgestaltung wird daher ein Isoliertes Metallsubstrat bzw. IMS verwendet, bei dem die Isolationsschicht und das Metallsubstrat mittel eines noch nicht vollständig ausgehärteten Klebers miteinander verbunden sind. Erst in einem weiteren Prozessschritt wird der Kleber, beispielsweise durch Wärmezufuhr, vollständig ausgehärtet.

Vorzugsweise werden mehrere flexible elektrische Vorrichtungen in parallel oder seriell verlaufenden Fertigungsprozessen aus dem Isolierten Metallsubstrat bzw. IMS gefertigt.

Die flexible elektrische Vorrichtung, wie ein flexibles Flachkabel oder eine flexible Leiterplatte, oder Kombinationen davon können mit beliebigen elektrischen Bauteilen bestückt werden. Die Verwendung der Kühlkörper erlaubt beispielsweise den Einsatz von Leuchtdioden (LED) in hoher Packungsdichte. Anhand einer erfindungsgemässen flexiblen elektrischen Vorrichtung können daher beliebig geformte Leuchtkörper realisiert werden, wie sie im Automobilbau benötigt werden. Durch Formung der flexiblen elektrischen Vorrichtung kann dem Leuchtkörper eine beliebige regelmässige oder unregelmässige Abstrahlcharakteristik zugeordnet werden. Vorzugsweise werden die Kühlkörper mit wenigstens einer Vertiefung versehen sind, in der wenigstens eine Leuchtdiode oder wenigstens ein Leuchtdioden-Chip (COB) angeordnet ist. Durch den Einsatz von Single-Chip-Computern kann die flexible elektrische Vorrichtung ein Netzwerk mit verteilter Intelligenz und/oder verteilter Leistungselektronik bilden, mittels der dezentral unterschiedliche Aufgaben gelöst werden.

Abgelöste Teile des Metallsubstrats werden wieder verwendet, so dass diesbezüglich keine Verluste entstehen.

Die Erfindung wird nachstehend anhand von Zeichnungen näher erläutert. Dabei zeigt in Schnittdarstellung:
- Figur 1: eine bekannte Anordnung eines LED-Chips 2 auf einem Isolierten Metallsubstrat (IMS) 1;
- Figur 2: ein in [4] beschriebenes Isoliertes Metallsubstrat (IMS) 1 bestehend aus einem mit einer Vertiefung 121 versehenen Metallsubstrat 12, an dessen Oberseite eine Isolationsschicht 11 mit elektrischen Bahnen 10 angeordnet ist, an die eine in Chip-Form vorliegende, innerhalb der Vertiefung 121 angeordnete Leuchtdiode 2 angeschlossen ist;
- Figur 3: ein Isoliertes Metallsubstrat (IMS) 1, das mit der Isolationsschicht 11 oben liegend auf einen Werktisch 99 abgelegt ist, sowie ein erstes Werkzeug 91, mittels dessen z.B. konische Vertiefungen 121 durch die Isolationsschicht 11 in das Metallsubstrat 12 eingearbeitet werden;
- Figur 4: das Isolierte Metallsubstrat (IMS) 1 von Figur 3, das mit der Isolationsschicht 11 unten liegend auf den Werktisch 99 abgelegt ist, sowie ein zweites Werkzeug 92, mittels dessen das Metallsubstrat 12 partiell von der Isolationsschicht 11 abgelöst wird;
- Figur 5: ein erfindungsgemäss bearbeitetes Isoliertes Metallsubstrat IMS 1 bzw. eine daraus gefertigte flexible elektrische Vorrichtung 100 mit einer mittels des zweiten Werkzeugs 92 gefertigten Ausnehmung 125, im Bereich derer das Metallsubstrat 12 von der Isolationsschicht 11 abgelöst ist;
- Figur 6: eine flexible elektrische Vorrichtung 100 mit mehreren auf einem Metallsubstratelement bzw. einem Kühlkörper 120 angeordneten LED-Chips 2 und einer daran anschliessenden mit Leiterbahnen 10 versehenen Isolationsschicht 11, die als Band wenigstens zwei Kühlkörper 120 miteinander verbindet; und
- Figur 7: eine flexible elektrische Vorrichtung 100 mit wenigstens zwei Kühlkörpern 120, die beispielsweise mit Strukturelementen 8 eines Fahrzeugs verbunden sind.

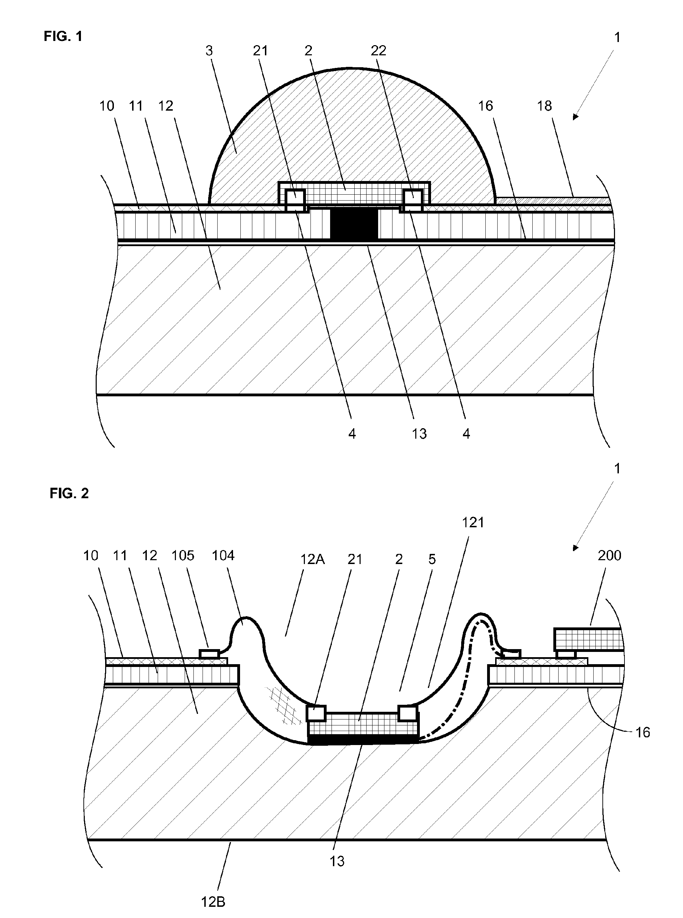

Figur 1 zeigt eine aus [4] bekannte Anordnung eines LED-Chips 2 auf einem Isolierten Metallsubstrat (IMS) 1. Das isolierte Metallsubstrat (IMS) 1 besteht aus einem Metallsubstrat 12, einer dielektrischen Isolationsschicht 11 und auf der Isolationsschicht 11 vorgesehenen elektrischen Bahnen 10, an die ein auf einem wärmeleitenden Element 13 ruhender LED-Chip 2 angeschlossen ist. Die Isolationsschicht 11 ist mittels einer Verbindungsschicht, beispielsweise einer Klebstoffschicht 16 mit dem Metallsubstrat 12 verbunden. Gezeigt sind ferner die mittels eines Lötmittels 4 verbundenen elektrischen Anschlusskontakte 21, 22 des LED-Chips 2 sowie eine Lackmaske 18 als Löt und Oberflächenschutz. Die vom LED-Chip 2 abgegebene thermische Energie wird mittels des wärmeleitenden Elements 13 vom LED-Chip 2 zum Metallsubstrat 12 transferiert. Zur Verbesserung der Abstrahleigenschaften ist ferner eine Linse oder eine Glaskappe 3 vorgesehen.

Figur 2 zeigt ein in [4] beschriebenes Isoliertes Metallsubstrat (IMS) 1 mit einem Metallsubstrat 12, einer Isolationsschicht 11 mit elektrischen Bahnen 10 und mit einem LED-Chip 2, der in einer Vertiefung 121 angeordnet ist, deren Wände als Reflektor 5 dienen. Der LED-Chip 2 ist mittels eines Klebers 13 mit dem Metallsubstrat 12 und dessen Anschlusskontakte 21 sind mittels Bonddrahtstellen 104 mit Anschlusskontakten 105 auf den elektrischen Bahnen 10 verbunden. In Figur 2 ist ferner gezeigt, dass auf dem Isolierten Metallsubstrat (IMS) 1 beliebige weitere Bauteile 200 angeordnet sein können.

Das Metallsubstrat 12 dient einerseits als Basis oder Halterung zur Montage der Bauteile 2, 200 und andererseits der Aufnahme der Verlustwärme von diesen Bauteilen 2, 200 insbesondere von den Leuchtdioden 2, von denen moderne Typen bereits sehr hohe Strahlungsleistungen aufweisen.

Die Isolierten Metallsubstrate (IMS) 1 von Figur 1 und 2 sind starr und werden beispielsweise mittels konventioneller Flachkabel verdrahtet. Wie erwähnt können die Isolierten Metallsubstrate (IMS) 1 auch gemäss dem in [4] offenbarten Verfahren bearbeitet werden, um diesen eine erforderliche Biegbarkeit zu verleihen.

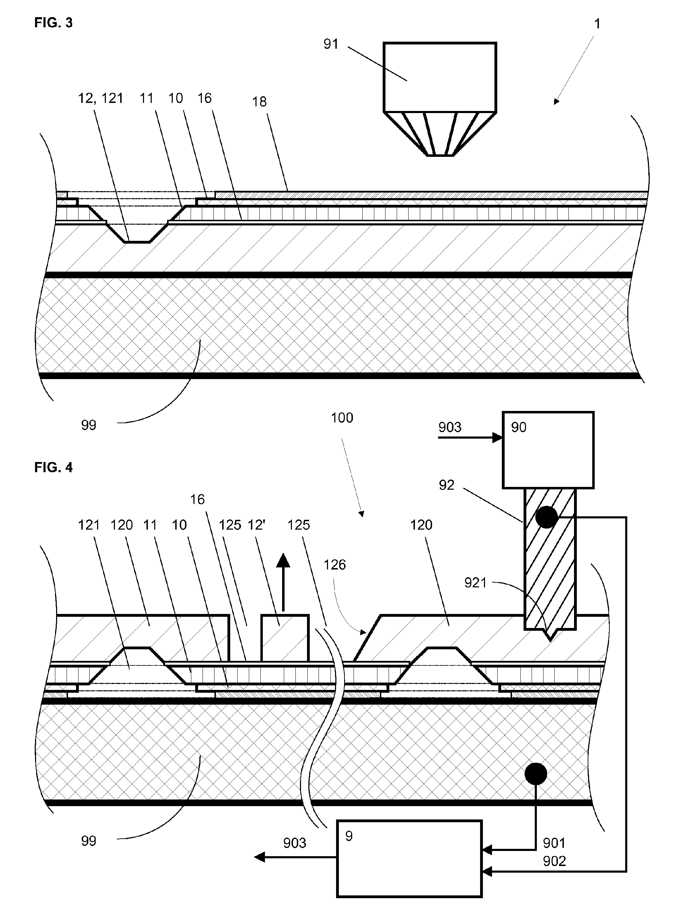

Figur 3 zeigt ein Isoliertes Metallsubstrat (IMS) 1, das mit der Isolationsschicht 11 oben liegend auf einen Werktisch 99 abgelegt ist. Ferner ist ein erstes Werkzeug 91 gezeigt, mittels dessen Vertiefungen 121 in wählbarer Form und Anzahl durch die Isolationsschicht 11 in das Metallsubstrat 12 eingearbeitet werden.

Figur 4 zeigt das Isolierte Metallsubstrat (IMS) 1 von Figur 3, das mit der Isolationsschicht 11 unten liegend auf den Werktisch 99 abgelegt ist. Ferner ist ein zweites Werkzeug 92 gezeigt, mittels dessen das Metallsubstrat 12 partiell von der Isolationsschicht 11 abgelöst wird, ohne diese in störender Weise zu beeinträchtigen. Das von einer Antriebsvorrichtung 90 geführte und angetriebene zweite Werkzeug 92, beispielsweise eine Fräse oder ein Bohrer, wird dabei nur so weit abgesenkt, bis das Metallsubstrat 12 an den erforderlichen Stellen abgetragen ist.

Besonders vorteilhaft kann dies durchgeführt werden, indem die Änderung des elektrischen Widerstands zwischen dem zweiten Werkzeug 92 und dem Werktisch 99 in einer Steuereinheit 9 ermittelt wird, die über Messleitungen 901, 902 mit dem zweiten Werkzeug 92 und dem Werktisch 99 verbunden ist. Sobald das zweite Werkzeug 92 die Isolationsschicht 11 oder mit einer Spitze den Werktisch 99 erreicht, wird dies von der Steuereinheit 9 detektiert, welche über eine Steuerleitung 903 den Vortrieb der Antriebsvorrichtung 90 stoppt und diese wieder zurückführt.

Mittels der programmierten Steuereinheit 9 können einfache oder auch komplexe Strukturen in das Metallsubstrat 12 eingearbeitet werden.

Beispielsweise kann ein zu entfernendes Segment 12' auch nur peripher von benachbarten Segmenten des Metallsubstrats 12 getrennt und anschliessend beispielsweise mittels eines Saugelements erfasst und von der Isolationsschicht 11 abgelöst werden. Besonders einfach ist dies möglich, wenn die Klebstoffschicht 16, welche das Metallsubstrat 12 und die Isolationsschicht 11 miteinander verbindet, noch nicht vollständig ausgehärtet ist. Die Klebstoffschicht 16 wird in diesem Fall vorzugsweise erst nach der Entfernung der entsprechenden Metallsegmente 12' abschliessend ausgehärtet.

In Figur 4 ist ferner gezeigt, dass in einer vorzugsweisen Ausgestaltung der Erfinder die Ränder 126 einer Ausnehmung 125 ebenfalls in passender Weise bearbeitet, beispielsweise abgeschrägt werden können, so dass die Form der Kühlkörper 120 beispielsweise der Form des Montagekörpers 8 entspricht, in den die Kühlkörper beispielsweise eingesenkt werden. Dazu ist jedoch Spezialwerkzeug erforderlich weshalb die Ränder bei Fehlen entsprechender Anforderungen senkrecht ausgestaltet werden.

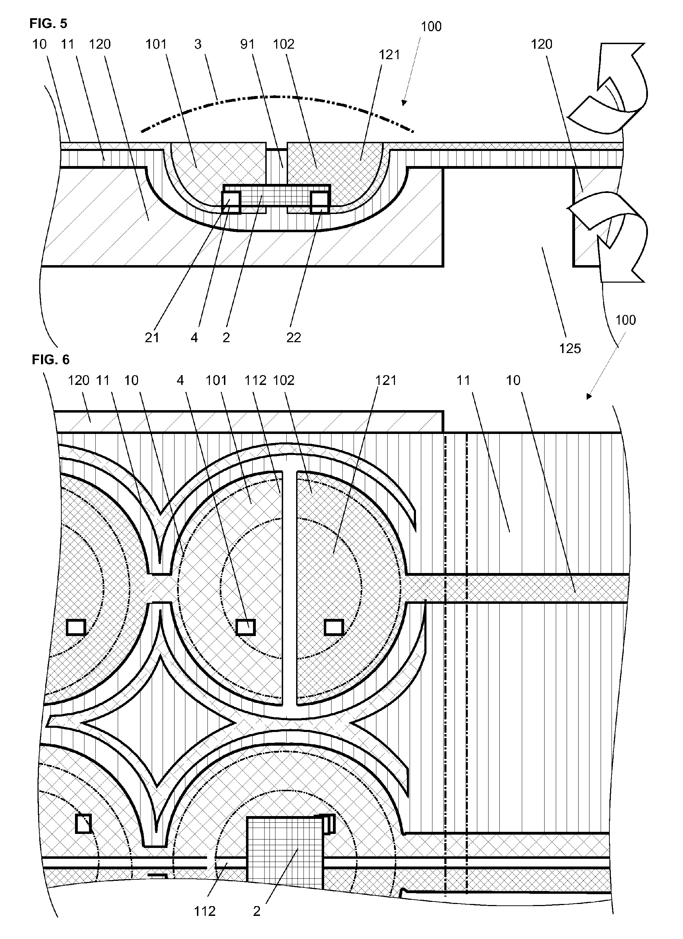

Figur 5 zeigt ein erfindungsgemäss bearbeitetes Isoliertes Metallsubstrat IMS 1 bzw. eine daraus gefertigte flexible elektrische Vorrichtung 100 mit einer Ausnehmung 125, im Bereich derer das Metallsubstrat 12 von der Isolationsschicht 11 abgelöst ist.

Das in Figur 5 gezeigte Metallsubstrat 12 ist vollständig mit der Isolationsschicht 11 bedeckt, die auch in die Vertiefung 121 hineingezogen ist (vergleiche Figur 2). Ebenfalls in die Vertiefung 121 hineingezogen ist die der Bildung der elektrisch leitenden Bahnen dienende Metallschicht 10. Etwa in der Mitte der Vertiefung 121 ist diese Metallschicht durch eine Aussparung 91 aufgetrennt, so dass zwei voneinander elektrisch getrennte Anschlussleitungen 101, 102 resultieren, die die Vertiefung 121 fast vollständig bedecken und einen Reflektor bilden. Das erfindungsgemässe Verfahren ist jedoch unabhängig von der Ausgestaltung und Bestückung des Isolierten Metallsubstrats (IMS) 1 anwendbar. Es ist davon auszugehen, dass das erfindungsgemässe Verfahren sogar zahlreiche neue Gestaltungsmöglichkeiten eröffnet.

Figur 6 zeigt eine flexible elektrische Vorrichtung 100 mit mehreren auf einem Metallsubstratelement bzw. einem Kühlkörper 120 angeordneten LED-Chips 2 und einer daran anschliessenden mit Leiterbahnen 10 versehenen Isolationsschicht 11, die als Band wenigstens zwei Kühlkörper 120 miteinander verbindet. Der gezeigte Kühlkörper 120 weist mehrere Vertiefungen 121 für LED-Chips 2 auf, mittels denen eine LED-Matrix gebildet wird. Mittels Ätztechnik oder Laserbehandlung sind die Metallbahnen 10 segmentiert. In der oberen Reihe sind die Metallbahnen 10 durch vertikal verlaufende Laserschnitte 112 aufgetrennt, wodurch Anschlussleitungen 101, 102 geschaffen wurden, an die die LED-Chips 2 in Serieschaltung anschliessbar sind. In der unteren Reihe sind die Metallbahnen 10 durch einen horizontal verlaufenden, durch Ätztechnik oder Laserbehandlung gefertigten Schnitt 112 aufgetrennt, wodurch Anschlussleitungen geschaffen wurden, an die LED-Chips 2 in Parallelschaltung anschliessbar sind.

In Figur 6 ist gezeigt, dass die mit elektrischen Leitungen 10 versehene Isolationsschicht 11 ein sich über eine längere Distanz erstreckendes Flachkabel bildet, welches die einfache Montage der mit Leuchtdioden-Chips 2 versehenen Kühlkörper 120 an unterschiedlichen Positionen beispielsweise innerhalb eines Fahrzeugs ermöglicht. Auf jedem Kühlkörper 120 können anhand der oben beschriebenen Technologie verschiedene weitere Bauteile, wie Sensoren oder Single-Chip-Computer montiert werden, welche einen autonomen Betrieb jeder auf einem Kühlkörper 120 vorgesehenen elektronischen Einheit ermöglichen.

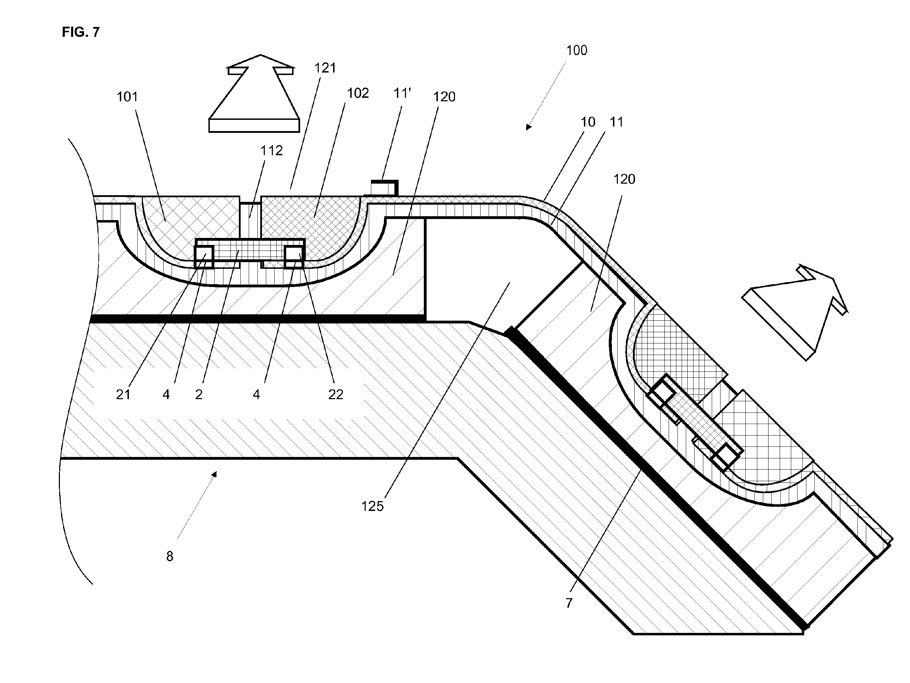

Figur 7 zeigt eine flexible elektrische Vorrichtung 100 mit wenigstens zwei Kühlkörpern 120, die mittels einer Klebstoffschicht 7 beispielsweise mit Strukturelementen 8 eines Fahrzeugs verbunden sind. In Figur 7 ist gezeigt, dass die Kühlkörper 120 beliebig gegeneinander geneigt oder gar gedreht werden können.

### Literaturverzeichnis

[1] US 2006169481 A1
[2] DE 102004061425 A1
[3] DE 10051269 A1
[4] EP 1 635 403 A1

## Patentansprüche

1. Verfahren zur Herstellung flexibler elektrischer Vorrichtungen (100), wie flexible Flachkabel und flexible Leiterplatten, die mit wenigstens zwei vollständig voneinander getrennten Kühlkörpern (120) versehen sind, welche der Aufnahme der Verlustwärme von elektrischen Bauteilen (2, 200), wie Halbleiter, Leuchtdioden, Halbleiterschaltmittel dienen, **dadurch gekennzeichnet, dass** das einseitig mit einer Isolationsschicht (11) und mit einer aussen liegenden Metallschicht (10) versehene Metallsubstrat (12) eines gegebenenfalls in vorhergehenden Schritten vorbearbeiteten Isolierten Metallsubstrats bzw. IMS (1) mittels eines Werkzeugs (92) derart bearbeitet wird, dass wenigstens ein Segment (12') des Metallsubstrats (12) vollständig von der Isolationsschicht (11) abgetrennt wird, so dass das Metallsubstrat (12) in zwei oder mehrere Kühlkörper (120) aufgeteilt wird, die durch die freigelegte Isolationsschicht (11) miteinander verbunden sind.

2. Verfahren nach Anspruch 1, **dadurch gekennzeichnet, dass** in den vorhergehenden Schritten oder in nachfolgenden Schritten
a) eine Lackmaske (18) auf die aussen liegende Metallschicht (10) aufgetragen wird; und/oder
b) die aussen liegende Metallschicht (10) bearbeitet wird, um Leiterbahnen oder Reflexionszonen zu bilden; und/oder
c) wenigstens eine Vertiefung (121) durch die Isolationsschicht (11) in das Metallsubstrat (12) eingearbeitet wird; und/oder
d) elektrische Bauteile (2), wie Schaltmittel und Leuchtdioden, gegebenenfalls innerhalb der Vertiefung (121), mit den Leiterbahnen verbunden werden; und/oder
e) Schichten, gegebenenfalls Schutz- oder Veredelungsschichten aus Materialien wie Lack, Kunststoff, Metall oder Edelmetall aufgetragen werden.

3. Verfahren nach Anspruch 1 oder 2, **dadurch gekennzeichnet, dass** das Isolierte Metallsubstrat bzw. IMS (1) mit der Isolationsschicht (11) nach unten auf einen Werktisch (99) gelegt und das von einer Steuereinheit (9) gesteuerte Werkzeug (92) soweit in das Metallsubstrat (12) eingesenkt wird, bis der zwischen dem Werktisch (99) und dem Werkzeug (92) resultierende elektrische Widerstand, der von der Steuereinheit (9) gemessen und überwacht wird, einen vorgesehenen Schwellwert unterschreitet.

4. Verfahren nach Anspruch 1, 2 oder 3, **dadurch gekennzeichnet, dass** die Isolationsschicht (11) aus Polyester, Polyvinyl, Polyethylen, Polyimid oder Polycarbonat besteht und/oder dass das Metallsubstrat (12) aus Aluminium oder Kupfer besteht und/oder dass die Dicke und Beschaffenheit der Isolationsschicht (11) und/oder der elektrischen Leiterbahnen entsprechend der erforderlichen Festigkeit der Verbindung zwischen den Kühlkörpern (120) gewählt wird..

5. Verfahren nach einem der Ansprüche 1-4, **dadurch gekennzeichnet, dass** die Ränder (126) der Kühlkörper (120) mit einer Form versehen werden, die gegebenenfalls zur Form des Montagekörpers (8) korrespondiert.

6. Verfahren nach einem der Ansprüche 1-5, **dadurch gekennzeichnet, dass** die Klebeverbindung und der Kleber (16) zwischen der Isolationsschicht (11) und dem Metallsubstrat (12) derart gewählt ist, dass freigelegte Metallsegmente (12') abgelöst werden können und/oder dass die Klebeverbindung und der Kleber (16) zwischen der Isolationsschicht (11) und dem Metallsubstrat (12) derart gewählt ist, dass freigelegte Metallsegmente (12') abgelöst werden können und der Kleber (16) in einem nachfolgenden Verfahrensschritt, gegebenenfalls durch Wärmezufuhr vollständig ausgehärtet wird.

7. Verfahren nach einem der Ansprüche 1-6, **dadurch gekennzeichnet, dass** mehrere flexible elektrische Vorrichtungen (100) in parallel oder seriell verlaufenden Fertigungsprozessen aus dem Isolierten Metallsubstrat bzw. IMS (1) gefertigt werden und/oder dass eine oder mehrere flexible elektrische Vorrichtungen (100) in einer für die Verwendung erforderlichen Form aus dem Isolierten Metallsubstrat bzw. IMS (1) ausgeschnitten werden.

8. Flexible elektrische Vorrichtung (100), wie ein flexibles Flachkabel oder eine flexible Leiterplatte gefertigt gemäss dem Verfahren nach einem der Ansprüche 1-7, aus einem Isolierten Metallsubstrat bzw. IMS (1), das ein Metallsubstrat (12), eine teilweise freigelegte Isolationsschicht (11) und eine Metallschicht und/oder daraus gefertigte Leiterbahnen (10) aufweist, welche mit elektrischen Bauteilen, insbesondere Halbleitern, wie Schalteinheiten und/oder Leuchtdioden verbunden sind.

9. Flexible elektrische Vorrichtung (100) nach Anspruch 8, **dadurch gekennzeichnet, dass** die vorzugsweise aus Polyester, Polyvinyl, Polyethylen, Polyimid oder Polycarbonat bestehende Isolationsschicht (11) zwei oder mehrere aus dem Metallsubstrat (12) resultierende Kühlkörper (120) miteinander verbindet.

10. Flexible elektrische Vorrichtung (100) nach Anspruch 8 oder 9, **dadurch gekennzeichnet, dass** die Kühlkörper (120) mit wenigstens einer Vertiefung (121) versehen sind, in der wenigstens eine Leuchtdiode oder wenigstens ein Leuchtdioden-Chip (COB) angeordnet ist.
